# EUROPÄISCHE PATENTANMELDUNG

(11) **EP 1 814 227 A2**
(43) Veröffentlichungstag der Anmeldung: **01.08.2007**
(21) Anmeldenummer: 07000418.9
(22) Anmeldetag: 10.01.2007
(51) Int. Cl.: H03K 17/96

(54) **Bedieneinrichtung für ein Elektrogerät und Elektrogerät mit einer solchen Bedieneinrichtung**

(30) Priorität: 30.01.2006 DE 102006005677
(71) Anmelder: E.G.O. ELEKTRO-GERÄTEBAU GmbH, 75038 Oberderdingen (DE)
(72) Erfinder: Baier, Martin, 76275 Ettlingen (DE)
(74) Vertreter: Patentanwälte Ruff, Wilhelm, Beier, Dauster & Partner

(57) **Zusammenfassung**

Bei einer Bedieneinrichtung für ein Kochfeld mit einem LC-Display (11) kann vorgesehen sein, dass auf die Oberseite der unteren von zwei Platten (12, 13) des LC-Display ein Mikrocontroller als Halbleiterchip (30) direkt aufgebracht ist, beispielsweise durch COG-Technik. Dieser Halbleiterchip (30) steuert nicht nur das LC-Display (11) an, sondern auch an dem LC-Display angeordnete kapazitive Sensorelemente (20, 21) und wertet diese auch aus. So wird eine eigenständige Baueinheit gebildet. Diese kann über geeignete elektrische Verbindungen (34', 36) mit dem Kochfeld (43) verbunden sein und dieses unter Umständen zumindest teilweise oder sogar ganz steuern.

## Beschreibung

### Anwendungsgebiet und Stand der Technik

Die Erfindung betrifft eine Bedieneinrichtung für ein Elektrogerät sowie ein Elektrogerät mit einer solchen Bedieneinrichtung.

Aus der DE 100 11 645 A ist es bekannt, sogenannte Berührungsschalter bzw. deren Sensorelemente in ein LC-Display zu integrieren. Damit ist zwar eine gewisse Integration von Einzelteilen bzw. Funktionen möglich. Für die Anwendung beispielsweise in Kochfeldern jedoch wird immer häufiger gewünscht, Anzeigen und Bedienelemente in einen Rahmen bzw. in einen Rahmenbereich, der um eine Kochfeldplatte eines Kochfeldes verläuft, zu platzieren.

### Aufgabe und Lösung

Der Erfindung liegt die Aufgabe zugrunde, eine eingangs genannte Bedieneinrichtung sowie ein Elektrogerät zu schaffen, mit denen Probleme des Standes der Technik gelöst werden und Nachteile vermieden werden sowie insbesondere die Anordnung einer Bedieneinrichtung an einem Elektrogerät flexibler gemacht wird.

Gelöst wird diese Aufgabe durch eine Bedieneinrichtung mit den Merkmalen des Anspruchs 1 sowie ein Elektrogerät mit den Merkmalen des Anspruchs 13. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Es ist vorgesehen, dass das LC-Display zwei parallele Platten aufweist, die aufeinander aufliegen bzw. einen geringen Abstand zueinander aufweisen, wobei einzelne Segmente bzw. Symbole auf an sich übliche Art und Weise dargestellt werden können. Des weiteren weist die Bedieneinrichtung Sensorelemente eines Berührungsschalters auf, wie sie beispielsweise als kapazitive Sensorelemente aus der vorgenannten DE 100 11 645 A bekannt sind. Erfindungsgemäß ist auf einer Seite einer Platte ein elektronischer Schaltkreis bzw. Halbleiterchip angeordnet bzw. befestigt, so dass LC-Display und Schaltkreis eine Baueinheit bilden. Dieser elektronische Schaltkreis bzw. Halbleiterchip ist für Funktionen wie ein Ansteuern des LC-Displays und der Sensorelemente und/oder Auswerten der Sensorelemente ausgebildet. So kann also erfindungsgemäß eine Baueinheit eines LC-Displays mit Sensorelementen eines Berührungsschalters zusammen mit einem elektronischen Schaltkreis bzw. Halbleiterchip, beispielsweise als Mikrocontroller, zur Ansteuerung bzw. Auswertung geschaffen werden. Durch eine derartige Integration von Funktionen und Bauteilen ist es beispielsweise möglich, Signalwege zwischen Sensorelementen und Auswertung möglichst kurz zu machen um die Störanfälligkeit zu senken. Des weiteren kann eine Bedieneinrichtung mit sozusagen eigener Intelligenz als eigenständige Baueinheit geschaffen werden. Der Schaltkreis bzw. Halbleiterchip kann für weitere Aufgaben ausgebildet sein, was nachfolgend noch näher erläutert wird.

Zur Anordnung bzw. Befestigung des Halbleiterchips an dem LC-Display ist es gemäß einer Ausführung der Erfindung möglich, ihn direkt auf eine der Platten aufzubringen. Dazu kann er entweder aufgeklebt sein bzw. in einer aus der Chip-on-glass-Technologie bekannten entsprechenden Weise aufgebracht sein.

Gemäß einer anderen Ausführung der Erfindung kann der Halbleiterchip auf einen dünnen flexiblen Träger aufgebracht sein, beispielsweise eine Leiterplatte oder eine Folie. Dieser Träger wiederum ist mit dem LC-Display bzw. einer der Platten verbunden, beispielsweise verklebt und elektrisch kontaktiert. So kann ebenfalls die gewünschte Baueinheit geschaffen werden, wobei insbesondere durch das Aufbringen des Halbleiterchips auf den Träger der unter Umständen technologisch etwas schwierigere Befestigungs-Schritt unabhängig von dem LC-Display stattfindet. Die Befestigung des Trägers an dem LC-Display kann durch eine Verklebung erfolgen. Vorzugsweise ist der Träger dabei flächig mit einer Seite einer Platte des LC-Displays verbunden bzw. verklebt. Elektrische Leiter odgl. können auf dem Träger vorhanden sein und zu Kontaktfeldern auf dem Träger führen. So wird eine Anschlussmöglichkeit an eine elektrische Kontaktierung des Elektrogerätes gebildet. Ist der Halbleiterchip direkt auf das LC-Display aufgebracht, so sind elektrische leiterähnliche Leiterbahnen odgl. vorteilhaft auch direkt auf das LC-Display aufgebracht.

Als eine weitere Verwendungsmöglichkeit des Halbleiterchips zu seiner besseren Ausnutzung kann vorgesehen sein, ihn zur Steuerung eines Teils des gesamten Elektrogerätes, beispielsweise einzelner Funktionseinheiten, oder sogar des gesamten Elektrogerätes auszubilden, beispielsweise als Mikrocontroller. Vorteilhaft ist er dabei der einzige Halbleiterchip, wodurch der Aufwand begrenzt werden kann. Beispielsweise können über ihn Funktionseinheiten odgl. des Elektrogerätes gesteuert werden, insbesondere wenn sie über die Bedieneinrichtung bestimmt oder ausgelöst werden.

Es wird als vorteilhaft angesehen, den Halbleiterchip auf die Oberseite der im Betriebszustand der Bedieneinrichtung nicht außenliegenden bzw. unteren Platte aufzubringen. So ist es möglich, ihn sowie seine mechanische Befestigung vor Beschädigung zu schützen.

Es ist von Vorteil, wenn die vorgenannten Sensorelemente auf der gleichen Fläche aufgebracht sind wie der Schaltkreis bzw. Halbleiterchip. Dabei kann vor allem bei einer vorgenannten Anordnung des Halbleiterchips an einem Träger, der wiederum an einer der Platten befestigt ist, auch die Anordnung der Sensorelemente dort erfolgen. Insbesondere sind es kapazitive Sensorelemente, die dabei vorteilhaft flächig ausgebildet sind, wobei dem Fachmann verschiedene Sensorelemente bekannt sind, beispielsweise aus der DE-A-10326684 und der DE-A-102004043415, und eine Ausführung möglich sein sollte.

Es ist im Rahmen der Erfindung möglich, eine Bedieneinrichtung als eigenständig handhabbare Baueinheit so auszubilden, dass als elektrischer Anschluss an das Elektrogerät nur Anschlüsse für eine Versorgungsspannung vorzusehen sind wie ein Masseanschluss und ein Anschluss für einen seriellen Bus. Über diesen seriellen Bus kann eine sonstige Datenverbindung mit dem Elektrogerät stattfinden wie auch beispielsweise ein Leistungsteil des Elektrogerätes angesteuert werden über Befehle, die über die Bedieneinrichtung eingegeben werden.

Dabei kann in weiterer Ausgestaltung der Erfindung vorgesehen sein, dass nicht nur der Halbleiterchip der einzige ist für das gesamte Elektrogerät, sondern auch keine weiteren Sensorelemente oder Bedienelemente an dem Elektrogerät vorgesehen sind bis auf unter Umständen einen Ein-/Aus-Schalter. Dies vereinfacht den Aufbau des Elektrogerätes. Des weiteren ist es dadurch möglich, eine defekte Bedieneinrichtung schnell und einfach auszutauschen. Schließlich können bei Geräte- bzw. Variantenvielfalt aufbauend auf ähnlichen oder gleichen Grundgeräten verschiedene Funktionalitäten über unterschiedliche Bedieneinrichtungen vorgesehen sein, beispielsweise unterschiedlich ausgestaltete Programmvarianten.

Vorteilhaft wird die Bedieneinrichtung relativ dünn ausgeführt, so dass sie beispielsweise auch auf einer Fläche des Elektrogerätes angeordnet werden kann. Beispielsweise kann dies bei einem Kochfeld im Randbereich, auf der Kochfeldplattenfläche oder seitlich neben oder vor einem Kochfeld sein. Alternativ kann die Bedieneinrichtung auch direkt neben einem Kochfeld angeordnet sein. Damit ist es auch möglich, Leiter odgl. für einen elektrischen Anschluss nicht freiliegend unter das Kochfeld zu führen, sondern direkt von der an die Kochfeldplatte angrenzenden Bedieneinrichtung.

Darüber hinaus ist es möglich, die Sensorelemente nicht an der gleichen Platte bzw. in etwa der gleichen Ebene wie den Halbleiterchip an dem LC-Display anzuordnen, sondern an einer weiteren Platte oder einem weiteren Träger. Eine Verbindung mit dem Halbleiterchip zur Ansteuerung und/oder Auswertung kann über entsprechende Leiter erfolgen, beispielsweise flexible Leiter nach Art von Mehrfach-Flachkabeln oder Folienleitern. Diese Platte oder dieser Träger mit den Sensorelementen kann auch oberhalb des LC-Displays angeordnet sein bzw. auf seiner Oberseite. Dies ist vor allem dann von Vorteil, wenn die Sensorelemente möglichst nahe an einer Berühroberfläche bzw. Bedienoberfläche der Bedieneinrichtung angeordnet sein sollten. Des weiteren können die Sensorelemente innerhalb der Platten bzw. dazwischen angeordnet sein, wie es beispielsweise in der vorbeschriebenen DE 100 11 645 A beschrieben ist.

In weiterer Ausgestaltung kann das LC-Display hinterleuchtet sein, so dass eine Anzeige möglichst gut erkennbar ist. Des weiteren kann es farbig sein, wodurch die Informationsdarstellung komfortabler und vielfältiger möglich ist. Weitere Varianten für ein LC-Display können Verwendung finden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigt:
- Fig. 1: einen Schnitt durch ein LC-Display bzw. eine Bedieneinrichtung mit Sensorelementen und einem an der Oberseite der unteren Platte angebrachten Halbleiterchip,
- Fig. 2: eine alternative Anbringung des Halbleiterchips auf einem Folienleiter zwischen LC-Display und Elektrogerät und
- Fig. 3: das LC-Display aus Fig. 1 vor einem Kochfeld als dessen Bedieneinrichtung und Steuerung.

### Detaillierte Beschreibung der Ausführungsbeispiele

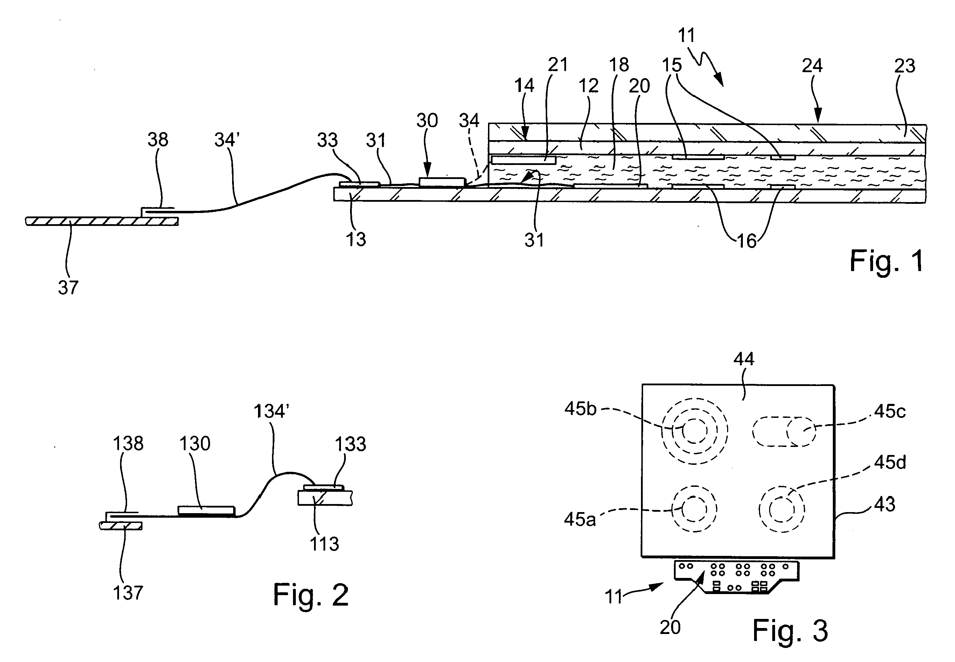

Fig. 1 zeigt eine Bedieneinrichtung bzw. ein LC-Display 11 im Schnitt, das eine obere Platte 12 und eine untere Platte 13 aufweist. Anstelle von Glasplatten als Platten können auch andere transparente Materialien verwendet werden, beispielsweise Kunststoff. Für Details wird hier auf die vorgenannte DE 100 11 645 A1 verwiesen, deren Inhalt diesbezüglich zum Inhalt der vorliegenden Beschreibung gemacht wird.

Zwischen den Platten 12 und 13 befinden sich eine obere leitfähige Schicht 15 und eine untere leitfähige Schicht 16 in einzelnen Abschnitten, die einander entsprechen. Zusammen mit dem zwischen den Glasplatten 12 und 13 befindlichen Flüssigkristall 18 dienen sie zur Darstellung der Symbole. Dies ist allgemein bekannt.

Für die Anbringung von Sensorelementen eines Berührschalters, insbesondere von kapazitiven Sensorelementen, sind mehrere Beispiele gegeben. Einerseits kann ein flächiges Sensorelement durch einen separaten ansteuerbaren Teil der Funktionsschichten 15 oder 16 gebildet werden, insbesondere als kapazitives Sensorelement bzw. als Sensorelement mit kapazitiver Kopplung nach außen. Weitere Sensorelemente 20 und 21 können unabhängig von den Funktionsschichten 15 und 16 zwischen den Glasplatten 12 und 13 vorgesehen sein, beispielsweise an der oberen Seite der unteren Platte 13 und an der Unterseite der oberen Glasplatte 12. Schließlich kann noch ein Sensorelement oberhalb der oberen Glasplatte 12 und unter einer Abdeckung 23 vorgesehen sein.

Die Abdeckung 23 auf dem LC-Display 11 kann eine Glasplatte odgl. sein und, als transparente Abdeckung, nicht nur einen Bereich des LC-Displays 11 überdecken sondern den größten Teil bzw. vollflächig. So kann die Abdeckung 23 insbesondere als mechanischer Schutz für das LC-Display dienen, da üblicherweise die obere Platte 12 nicht so stabil ausgebildet wird, wie sie es für eine Alltagsbeanspruchung als Bedieneinrichtung mit Berührungsschaltern sein sollte.

Die durchsichtige Abdeckung 23 kann beispielsweise eine relativ stabile, wenige oder einige Millimeter dicke Glasplatte sein, beispielsweise aus möglichst hartem und/oder möglichst kratzfestem Glas. Ein weiteres Sensorelement könnte dabei unter Umständen auch auf die Unterseite der Abdeckung aufgebracht werden durch ein Verfahren wie bei den übrigen Sensorelementen.

An der Oberseite der unteren Platte 13 ist ein Halbleiterchip 30 angebracht. Ist die untere Platte 13 aus Glas, so kann eine COG-Technik (Chip-on-glass-Technik) dazu verwendet werden. Diese ist für den Fachmann an sich bekannt und wird beispielsweise auch in der DE 10 2004 004 022 A1 beschrieben, auf die hier ausdrücklich verwiesen wird.

Von dem Halbleiterchip 30 gehen ebenfalls an der Oberseite der unteren Platte 13 entlang Leiterbahnen 31 ab, und zwar sowohl nach links als auch nach rechts bzw. in alle Richtungen. Sie dienen zur elektrischen Verbindung des Halbleiterchips mit sonstigen Funktionseinrichtungen, wie im folgenden näher erläutert wird. Beispielsweise führt die nach links gehende Leiterbahn 31 zu einem linken Kontaktfeld 33, welches beispielsweise eine Metallschicht an der Oberseite der unteren Glasplatte 13 ist. Über einen flexiblen Leiter 34' geht eine Verbindung zu den unteren linken Kontaktfeldern 38 auf der Leiterplatte 37. Ein solcher flexibler Leiter 34' ist vorteilhaft ein Folienleiter als eine mit Leiterbahnen versehene Folie, unter Umständen auch ein entsprechend vieladriger Draht bzw. Kabel odgl.. Die Leiterplatte 37 kann Teil eines Elektrogerätes wie beispielsweise eines Elektro-Wärmegerätes sein, das mit der Bedieneinrichtung 11 bzw. dem LC-Display bedient wird und darauf seine Informationen anzeigt. Eine andere Möglichkeit zur Verbindung mit der Leiterplatte 37 bzw. anderen Einrichtungen eines Elektrogerätes ist über nicht dargestellte Stecker bzw. Mehrfach-Stecker als elektrische Verbindung.

Über die elektrischen Verbindungen 31, 33, 34 und 34' ist es möglich, den Schaltkreis 30 mit der Leiterplatte 37 und Halbleiterchip 30 bzw. mit dem Elektrogerät zu verbinden, so dass er für das Elektrogerät dieselben Funktionen übernimmt, die sonst ein speziell vorgesehener weiterer Schaltkreis bzw. Halbleiterchip als Steuerung erfüllen müsste. So ist es also möglich, dass der Halbleiterchip 30 die gesamte Steuerung des Elektrogerätes übernimmt und an dem Elektrogerät selber lediglich ein Schaltkreis als Empfänger für den seriellen Bus vorzusehen ist, jedoch keine komplette Steuerung.

Das Sensorelement 20 ist über eine Art Leiterbahn 31 mit dem Halbleiterchip 30 verbunden, wobei die Leiterbahn oder die elektrische Verbindung 31 sozusagen aus dem LC-Display bzw. dem Raum zwischen den Platten herausgeführt ist. Die an der oberen Platte 13 angeordneten Sensorelemente 21 sind über gestrichelt dargestellte flexible Leiter 34 ebenfalls mit dem Halbleiterchip 30 verbunden zur Ansteuerung und Auswertung. Für die jeweilige Ausgestaltung der Kontaktierung gibt es zahlreiche Möglichkeiten, deren Auswahl für den Fachmann kein Problem darstellt.

Somit ist aus Fig. 1 zu erkennen, wie eine Bedieneinrichtung 11 bzw. ein LC-Display als eine eigenständige Baueinheit zusammen mit dem Halbleiterchip 30 sozusagen als Intelligenz der Bedieneinrichtung ausgestaltet sein kann. Der abgehende Folienleiter 34' zählt hier vorteilhaft noch dazu. Diese eigenständige Baueinheit kann die Abdeckung 23 bereits aufweisen oder noch mit dieser versehen werden. Über die verschiedenen elektrischen Kontaktierungen über Leiterbahnen 31, flexible Leiter 34 und 34' und Kontaktfelder 33 für Mehrfach-Steckkontakte kann eine elektrische Verbindung mit dem zugehörigen Elektrogerät hergestellt werden. Eine derartige elektrische Verbindung kann beispielsweise lediglich Anschlüsse für eine Versorgungsspannung des Halbleiterchips 30, einen Masseanschluss und Anschlüsse für einen seriellen Bus vorsehen. Wenn das Elektrogerät lediglich einen Leistungsteil für seine elektrischen Funktionseinrichtungen aufweist, kann dessen Ansteuerung vorteilhaft über diese Bedieneinrichtung 11 bzw. den Halbleiterchip 30 erfolgen.

Eine weitere Ausführungsmöglichkeit der Erfindung ist in der Abwandlung gemäß Fig. 2 dargestellt. Hier ist der Halbleiterchip 130 nicht direkt auf der Oberseite der unteren Platte 113 des LC-Displays bzw. überhaupt daran befestigt. Vielmehr ist er direkt auf einen speziellen Folienleiter 134' aufgebracht, ähnlich wie der Folienleiter 34' aus Fig. 1 ausgebildet sein kann. Er kann direkt auf dem Folienleiter 134' aufgebracht sein oder über geeignete Zwischenschichten. Die Befestigung kann mit der COF-Technologie (Chip-on-foil-Technologie) erfolgen. Eine elektrische Kontaktierung an den Halbleiterchip 130 kann über die auf dem Folienleiter 134' ohnehin vorhandenen Leiterbahnen erfolgen. Der Folienleiter 134' an sich verläuft zwischen Kontaktfeldern 133 auf der Platte 113 und Kontaktfeldern 138 auf der Leiterplatte 137. Auf den Folienleiter 134' verlaufen somit auch die Signalleitungen zwischen dem Halbleiterchip 130 und den Sensorelementen, die hier nich dargestellt sind. Diese Art der Anbringung des Halbleiterchips 130 wird immer noch derart angesehen, dass er mit den Sensorelementen an dem LC-Display eine Baueinheit bildet.

Selbstverständlich gibt es bezüglich der Gestaltung des LC-Display hinsichtlich seiner Anzeigeeigenschaften noch weitere Möglichkeiten. So kann eine nicht dargestellte Hinterleuchtung vorgesehen sein auf im wesentlichen übliche Art und Weise. Des weiteren kann das LC-Display natürlich farbig sein, um sowohl mehr Informationen darstellen zu können als auch optisch ansprechender zu sein.

Das LC-Display 11 bzw. die Bedieneinrichtung kann gleichzeitig eine Art Bedieneinrichtung mit Steuereinrichtung mit integrierter Anzeige sein, die auch noch die Eingabeelemente bzw. Bedienelemente in Form von Berührungsschaltern aufweist, wie es in Fig. 3 dargestellt ist. Über entsprechende elektrische Verbindungen kann eine solche Bedieneinrichtung leicht an beliebiger Stelle an einem Elektrogerät angeordnet sein, beispielsweise vor dem Kochfeld 43 auf einer Arbeitsplatte odgl.. Eine elektrische Verbindung zu dem Kochfeld kann wiederum über den Folienleiter 34' entsprechend Fig. 1 erfolgen, genauso über den Folienleiter 134' entsprechend Fig. 2. Vorteilhaft ist dann die Bedieneinrichtung 11 so nahe an Kochfeld, dass der Folienleiter 34' nicht freiliegt, um ihn vor Beschädigung zu schützen. Auch andere Maßnahmen wie Abdeckungen odgl. können ausreichen. Der Ort der Anbringung des Halbleiterchips, also gemäß Fig. 1 oder Fig. 2, spielt hier keine besondere Rolle.

Die Bedieneinrichtung 11 ist dabei länglich ausgebildet, um die benötigten Sensorelemente 20 unterzubringen. Das Kochfeld 43 weist eine Kochfeldplatte 44 und vier Kochstellen 45a bis 45d auf. Die Bedieneinrichtung 11 bildet mit dem Halbleiterchip 30 die gesamte Steuerung bzw. Intelligenz des Kochfeldes 43. Dieses benötigt dann nur noch Leistungsmodule oder Leistungsrelais odgl., um die Signale zur Leistungserzeugung des Halbleiterchips 30 für die Kochstellen 45 umzusetzen zu deren Leistungsversorgung. Somit kann das Kochfeld 43 eben ohne Steuerung bzw. ohne eigene Intelligenz auskommen.

Eine alternative Anbringungsmöglichkeit für die Bedieneinrichtung 11 ist oben direkt auf dem Kochfeld 43, vorteilhaft entlang der vorderen Kante oder auch entlang einer seitlichen Kante. Ansonsten entspricht dies demjenigen, was zur Fig. 3 beschrieben worden ist.

## Patentansprüche

1. Bedieneinrichtung für ein Elektrogerät (43) mit einem LC-Display (11), wobei das LC-Display zwei parallele, aufeinander liegende Platten (12, 13, 113) aufweist und zur Darstellung einzelner Segmente bzw. Symbole ausgebildet ist und die Bedieneinrichtung Sensorelemente (20, 21) eines Berührungsschalters aufweist, **dadurch gekennzeichnet, dass** auf einer Seite einer der Platten ein Halbleiterchip (30, 130) daran angeordnet ist und für Funktionen wie Ansteuern des LC-Displays, Ansteuern der Sensorelemente und/oder Auswerten der Sensorelemente (20, 21) ausgebildet ist, wobei LC-Display (11) und Halbleiterchip (30, 130) eine Baueinheit bilden.

2. Bedieneinrichtung nach Anspruch 1, **dadurch gekennzeichnet, dass** der Halbleiterchip (30) direkt auf das LC-Display (11) bzw. eine der Platten (13) aufgebracht ist und mit diesen eine Baueinheit bildet, vorzugsweise in Chip-on-glass-Technologie.

3. Bedieneinrichtung nach Anspruch 1, **dadurch gekennzeichnet, dass** der Halbleiterchip (130) auf einen dünnen, flexiblen Träger (134') aufgebracht ist, der mit dem LC-Display bzw. einer Platte (113) verbunden ist, vorzugsweise in Chip-on-foil-Technologie, wobei insbesondere der Träger eine flexible und dünne Leiterplatte oder Folie (134') mit Leiterbahnen ist.

4. Bedieneinrichtung nach Anspruch 3, **dadurch gekennzeichnet, dass** der Träger (134') flächig mit einer Seite einer Platte (113) des LC-Displays verbunden ist, insbesondere flächig verklebt ist, wobei vorzugsweise auf dem Träger (134') elektrische Leiter zu Kontaktierungen (138) als Anschlussmöglichkeit geführt sind zum Anschluß an eine elektrische Kontaktierung des Elektrogerätes.

5. Bedieneinrichtung nach einem der vorhergehenden Ansprüche, **dadurch gekennzeichnet, dass** der Halbleiterchip (30, 130) auch zur Steuerung des Elektrogerätes ausgebildet ist, vorzugsweise als einzige Steuerung oder einziger Halbleiterchip bzw. Mikrocontroller.

6. Bedieneinrichtung nach Anspruch 1 oder 2, **dadurch gekennzeichnet, dass** der Halbleiterchip (30) auf die Oberseite der im Betriebszustand nicht außen liegenden bzw. nicht erreichbaren Platte (13) aufgebracht ist.

7. Bedieneinrichtung nach einem der vorhergehenden Ansprüche, **dadurch gekennzeichnet, dass** sie zum elektrischen Anschluß (34', 134') an das Elektrogerät nur Anschlüsse für eine Versorgungsspannung, für Masse und für einen seriellen Bus zur Steuerung eines Leistungsteils des Elektrogerätes durch den Halbleiterchip (30, 130) aufweist, wobei vorzugsweise sämtliche Bedienelemente des gesamten Elektrogerätes an der Bedieneinrichtung vorgesehen sind.

8. Bedieneinrichtung nach einem der vorhergehenden Ansprüche, **dadurch gekennzeichnet, dass** sie bzw. das LC-Display (11) nur wenige Millimeter dick ist, vorzugsweise weniger als drei Millimeter.

9. Bedieneinrichtung nach einem der vorhergehenden Ansprüche, **gekennzeichnet durch** eine weitere Platte (23), die mit dem LC-Display (11) verbunden ist, wobei sie vorzugsweise oberhalb des LC-Displays (11) angeordnet ist.

10. Bedieneinrichtung nach einem der Ansprüche 1 bis 8, **dadurch gekennzeichnet, dass** die Sensorelemente (20, 21) innerhalb der Platten (12, 13, 113) angeordnet sind.

11. Bedieneinrichtung nach einem der Ansprüche 1 bis 8, **dadurch gekennzeichnet, dass** wenigstens ein Sensorelement (20) an der Oberseite der unteren Platte (13, 113) angeordnet ist.

12. Bedieneinrichtung nach einem der vorhergehenden Ansprüche, **gekennzeichnet durch** eine Hinterleuchtung des LC-Displays (11).

13. Elektrogerät mit einer Bedieneinrichtung nach einem der vorhergehenden Ansprüche.

14. Elektrogerät nach Anspruch 13, **dadurch gekennzeichnet, dass** es ein Kochfeld (43) ist und die Bedieneinrichtung (11) im Außen- bzw. Rahmenbereich des Kochfeldes angeordnet ist, insbesondere direkt an einer Kochfeldplatte (44) aus Glaskeramik befestigt, vorzugsweise auf deren Oberseite.

15. Elektrogerät nach Anspruch 13, **dadurch gekennzeichnet, dass** es ein Kochfeld (43) ist und die Bedieneinrichtung (11) an einen Au-ßen- bzw. Rahmenbereich des Kochfeldes (43) angrenzend seitlich daneben angeordnet ist.
